# EUROPEAN PATENT APPLICATION

(11) **EP 2 197 058 A1**
(43) Date of publication of application: **16.06.2010**
(21) Application number: 08829887.2
(22) Date of filing: 03.09.2008
(51) Int. Cl.: H01L 35/34, H01L 35/08, H01L 35/14

(54) **METHOD FOR MANUFACTURING THERMOELECTRIC CONVERSION ELEMENT**

(30) Priority: 07.09.2007 JP 2007232986
(71) Applicant: Sumitomo Chemical Company, Limited, Tokyo 104-8260 (JP)
(72) Inventor: HIROYAMA, Yuichi, Tsukuba-shi Ibaraki 300-2617 (JP)
(74) Representative: Hart-Davis, Jason
(86) International application number: PCT/JP2008/066271
(87) International publication number: WO 2009/031695

(57) **Abstract**

Provided is a method for manufacturing a thermoelectric conversion element. The method includes a metal layer formation step of comprising spreading a metal compound which decomposes upon heating to generate a metal, on a surface of a thermoelectric conversion element main body heated to the decomposition temperature of the metal compound or higher.

## Description

### Technical Field

The present invention relates to a method for manufacturing a thermoelectric conversion element.

### Background Arts

In making a thermoelectric conversion module, a thermoelectric conversion element main body and an electrode are bonded using a bonding material such as solder. In many cases, the bonding property between the thermoelectric conversion element main body and the bonding material is not satisfactory compared with the bonding property between the electrode and the bonding material. Hence, it is a known practice to form a metal layer on the bonding surface of the thermoelectric conversion element main body for connecting the electrode in advance and then bond the metal layer and the electrode using the bonding material. Specifically, for example, it is a known practice to form a metal layer on the bonding surface of the thermoelectric conversion element main body for connecting the electrode using a method such as plating (Japanese Patent Application Laid-Open Publication No. 2006-40963 and Japanese Patent Application Laid-Open Publication No. 6-216413), thermal spraying, or spark plasma sintering (Japanese Patent Application Laid-Open Publication No. 2004-342879).

### Disclosure of the Invention

The metal layer formed on the surface of the thermoelectric conversion element main body using a conventional method, however, has not achieved sufficiently low contact resistance between the thermoelectric conversion element main body and the metal layer.

It is therefore an object of the present invention to provide a method for manufacturing a thermoelectric conversion element to achieve sufficiently low contact resistance between the thermoelectric conversion element main body and the metal layer.

The method for manufacturing a thermoelectric conversion element of the present invention comprises a metal layer formation step of comprising spreading a metal compound, which decomposes upon heating to generate a metal, on a surface of a thermoelectric conversion element main body heated to the decomposition temperature of the metal compound or higher.

According to the present invention, when the metal compound is spread on the surface of the thermoelectric conversion element main body heated to the decomposition temperature of the metal compound or higher, the metal compound is decomposed instantaneously and a metal layer is formed to cover the surface of the thermoelectric conversion element main body. Since the metal layer has high adhesion to the thermoelectric conversion element main body, the bonding strength between the thermoelectric conversion element main body and the metal layer increases and concurrently the contact resistance between the thermoelectric conversion element main body and the metal layer decreases.

It is preferable that the metal compound is a silver compound.

When a silver compound is used in the method for manufacturing the thermoelectric conversion element, a silver layer having higher adhesion to the thermoelectric conversion element can be provided as compared with silver paste which has been mostly used in the conventional art.

It is preferable that the silver compound is Ag₂O or Ag₂CO₃.

Ag₂O and Ag₂CO₃ have the relatively low decomposition temperatures, which is easily carried out. Since Ag₂O and Ag₂CO₃ remain unmelted until decomposition, a silver layer tends to outspread on the surface of the thermoelectric conversion element main body heated to the decomposition temperature of Ag₂O and Ag₂CO₃, or higher. Consequently, a metal layer having distinctly high adhesion to the thermoelectric conversion element main body can be formed.

Alternatively, the metal compound is preferably a metal oxide or a metal carbonate. A metal oxide or a metal carbonate decomposes to release oxygen gas or carbon dioxide gas and a metal layer with high adhesion can be formed.

It is preferable that the metal compound is at least one member selected from the group consisting of MnO₃, FeCO₃, Cu₂CO₃, NiCO₃, and MnCO₃, by which a film of copper, iron, nickel, or manganese can be formed.

It is preferable that the thermoelectric conversion element main body contains a metal oxide. Among the materials composing the thermoelectric conversion element main body, a metal oxide has insufficient wettability to metal in many cases. When the metal layer formation step is applied to the surface of the thermoelectric conversion element main body containing a metal oxide, a metal layer with high adhesion can be formed even though the thermoelectric conversion element main body contains a metal oxide.

In addition, the above metal oxide composing the thermoelectric conversion element main body is preferably Ca₃Co₄O₉ or CaMnO₃.

### Brief Description of the Drawings

Figure 1 is a perspective view (a) showing an example of the manufacturing process of the thermoelectric conversion element according to an embodiment of the present invention, and a perspective view (b) showing an example of the manufacturing process of the thermoelectric conversion element according to an embodiment of the present invention subsequent to Figure 1 (a); and
Figure 2 is a cross-sectional view showing an example of a thermoelectric conversion module 1.

### Description of Symbols

1: thermoelectric conversion module, 2: first substrate, 3: p-type thermoelectric conversion element main body , 4: n-type thermoelectric conversion element main body , 6: second electrode, 7: second substrate, 8: first electrode, 9: bonding material, 10: thermoelectric conversion element main body , 11: thermoelectric conversion element, 13: p-type thermoelectric conversion element, 14: n-type thermoelectric conversion element, 20: metal compound, 21: metal layer, 30: heater, 40: heating element, 50: medicine spoon, a, b: flat surface

### Best Modes for Carrying Out the Invention

With reference to the attached drawings, the preferred embodiments of the present invention will be explained below in detail. The same or corresponding elements are designated by the same reference symbols and overlapping explanation is omitted throughout the drawings. Dimensional ratios in the drawings do not necessarily correspond to actual dimensional ratios.

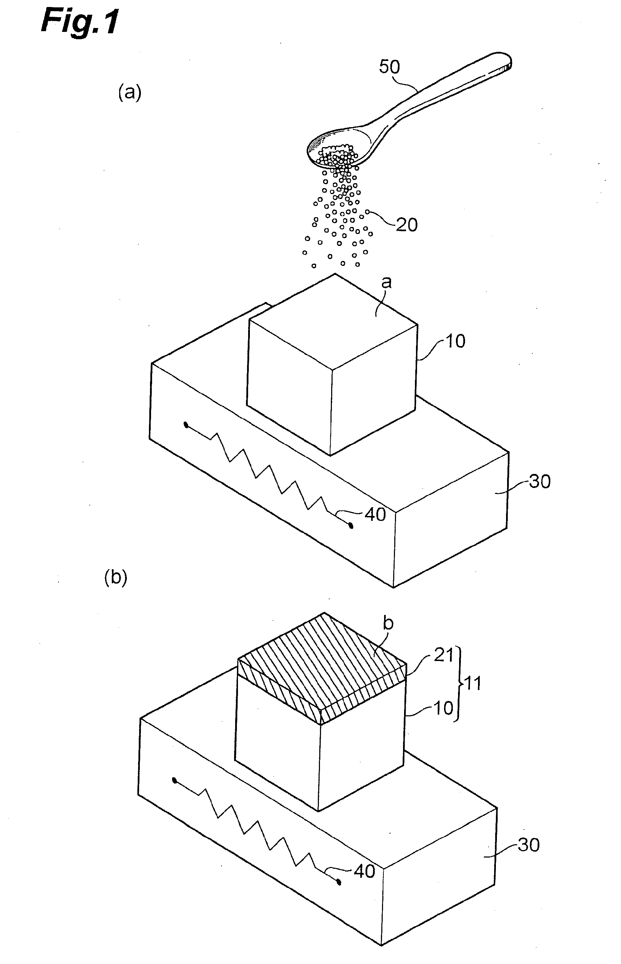

Figure 1 (a) is a perspective view showing an example of the manufacturing process of the thermoelectric conversion element according to an embodiment of the present invention, and Figure 1 (b) is a perspective view showing an example of the manufacturing process of the thermoelectric conversion element according to an embodiment of the present invention subsequent to Figure 1 (a).

First, the thermoelectric conversion element main body 10 is provided. Materials which may compose the thermoelectric conversion element main body 10 are not specifically limited, for which various materials such as a metal and a metal oxide can be used.

Examples of the p-type material composing the thermoelectric conversion element main body include mixed metal oxides such as NaₓCoO₂ and Ca₃Co₄O₉; silicides such as MnSi_{1.73}, Fe₁₋ₓMnₓSi₂, Si_{0.8}Ge_{0.2}, and β-FeSi₂; skutterudites such as CoSb₃, FeSb₃, and RFe₃CoSb₁₂ (R designates La, Ce or Yb.); and Te-containing alloys such as BiTeSb, PbTeSb, Bi₂Te₃, and PbTe.

Examples of the n-type material composing the thermoelectric conversion element main body include mixed metal oxides such as SrTiO₃, Zn₁₋ₓAlₓO, CaMnO₃, LaNiO₃, BaₓTi₈O₁₆, BaTiO₃, and Ti₁₋ₓNbₓO; silicides such as Mg₂Si, Fc₁₋ₓCoₓSi₂, Si_{0.8}Ge_{0.2}, and β-FeSi₂; skutterudites; clathrate compounds such as Ba₈Al₁₂Si₃₀ and Ba₈Al₁₂Ge₃₀; boron compounds such as CaB₆, SrB₆, BaB₆, and CeB₆; and Te-containing alloys such as BiTeSb, PbTeSb, Bi₂Te₃, and PbTe.

Specifically, since the metal oxides composing the thermoelectric conversion element main body have insufficient wettability to metal in many cases, it has been difficult in the conventional art to form a metal layer with high adhesion on the surface of the thermoelectric conversion element main body 10 comprising a metal oxide. In the present embodiment, however, materials comprising a metal oxide can be used as the thermoelectric conversion element main body 10, which is highly useful.

Among the metal oxides, Ca₃Co₄O₉ is preferable as p-type material and CaMnO₃ is preferable as n-type material. Ca₃Co₄O₉ and CaMnO₃ have excellent oxidation resistance in an air atmosphere at high temperature and also have high thermoelectric conversion efficiency.

Although the shapes of the thermoelectric conversion element main body 10 are not specifically limited, examples include hexahedrons such as a rectangular parallelepiped shown in Figure 1 (a) and disks.

Subsequently, a surface a of the thermoelectric conversion element main body 10 on which a metal layer 21 is to be formed is heated to the decomposition temperature of a metal compound 20 described below or higher. The heating temperature is preferably below the melting point of the metal generated by the decomposition of the metal compound 20. When the temperature of the surface a is equal to or higher than the melting point of the generated metal, the adhesion between the metal film and the surface a tends to decrease slightly, supposedly because the metal aggregate spherically.

Although the heating methods are not specifically limited, for example, as shown in Figure 1 (b), the thermoelectric conversion element main body 10 may be placed on a heater 30 having a built-in heating element 40.

Subsequently, a metal compound 20, which decomposes upon heating to generate a metal, is spread on the heated surface a.

The metal compound 20, which decomposes upon heating to generate a metal, is not specifically limited. As the metal compound 20, a metal compound which decomposes at or below the melting point or sublimation point of the metal compound 20 to generate a metal is preferable. Meanwhile, when a metal compound decomposes at the melting temperature of the metal compound or higher, or when a liquefied metal compound decomposes, the adhesion between the metal film and the surface tends to decrease slightly.

Specifically, a silver compound is preferable as the metal compound 20. Among silver compounds, Ag₂O which decomposes at 300°C, Ag₂CO₃ which decomposes at 218°C, and AgNO₃ which decomposes at 444°C are more preferable, because practice at lower temperature is feasible and the compounds decompose at the temperatures well below the melting point of the resulting silver (approximately 960°C). Particularly, Ag₂O and Ag₂CO₃ are furthermore preferable, because the silver layer tends to outspread due to decompose before melting.

When Ag₂O or Ag₂CO₃ is used as the metal compound 20, the heating temperature of the surface a of the thermoelectric conversion element main body 10 is in the range preferably not lower than 650°C and below the melting point of silver, more preferably not lower than 650°C and not higher than 750°C, and furthermore preferably not lower than 700°C and not higher than 720°C. The surface a having a temperature below 650°C makes the adhesion difficult between the thermoelectric conversion element main body 10 and the silver layer 21 and tends to cause easy peeling. On the other hand, the surface a having a temperature equal to or higher than the melting point of silver causes silver to aggregate spherically and the area covered with the silver layer decreases. Consequently, the silver layer 21 having an even thickness is difficult to achieve. As a result, the adhesion between the thermoelectric conversion element main body 10 and the silver layer 21 tends to decrease.

Metal oxides and metal carbonates are also preferable as the metal compound 20. Examples of the metal oxides include MnO₃ which has the decomposition temperature of 500°C. Examples of the metal carbonates include specifically FeCO₃ which has the decomposition temperature of 200°C, Cu₂CO₃ which has the decomposition temperature of 200°C, NiCO₃ which has the decomposition temperature of 230°C, MnCO₃ which has the decomposition temperature of 100°C.

It is preferable that the metal compound 20 is in particle state. Although the particle size is not specifically limited, the primary particle size is preferably from 0.01 µm to 100 µm, and more preferably from 0.1 µm to 1 µm. Powder with a size smaller than 0.01 µm tends to aggregate, while powder with a particle size larger than 100 µm makes it difficult to form an evenly thin metal layer.

Although the method for spreading the metal compound 20 on the surface a is not specifically limited, for example, a medicine spoon 50 shown in Figure 1 (a) or a quantitative powder supply apparatus may be used.

The ambient atmosphere in which the metal compound 20 is spread on the surface a is not specifically limited, and examples include an oxygen-containing atmosphere such as an air atmosphere; a reductive atmosphere such as an H₂ atmosphere; and an inert gas atmosphere such as Ar, N₂, He, and Ne. It is preferable that the atmosphere fails to inhibit the decomposition of the metal compound 20.

According to the method for manufacturing a thermoelectric conversion element 11 of the present invention, when the metal compound 20 is spread on the surface a of the thermoelectric conversion element main body 10 heated to the decomposition temperature of the metal compound 20 or higher, the metal compound 20 decomposes on the surface a, the metal layer 21 is formed on the surface a of the thermoelectric conversion element main body 10 to cover the surface a of the thermoelectric conversion element main body 10 as shown in Figure 1 (b), and a surface b composed of metal is newly formed.

Since the metal layer 21 has high adhesion to the thermoelectric conversion element main body 10, the bonding strength increases and concurrently the contact resistance decreases.

Although the reason that the metal layer 21 with high adhesion is formed by the embodiment is not obvious, the inference is outlined below. When a metal compound decomposes to generate a metal, it is contemplated that constituent elements of the metal compound other than metal elements are released as gas in many cases. When these elements other than the metal turn into gas to be released outwardly from the metal compound, a rapid volume expansion occurs in the metal compound to decompose the metal compound into metal on the molecular level. Since the microscopic metal like this adheres to the surface of the thermoelectric conversion element main body, it is contemplated that a metal layer with high adhesion can be formed.

Although the thickness of the metal layer 21 formed by spreading the metal compound 20 is not specifically limited, it is preferably from 1 µm to 1 mm from a standpoint of achieving the metal layer with a sufficient thickness to connect the thermoelectric conversion element 11 to an electrode. The metal layer 21 can be controlled by the amount per unit area of the spread metal compound 20, and can be also thinned by, for example, polishing after forming the metal layer 21.

In this way, the thermoelectric conversion element 11 having the metal layer 21 with high adhesion on the surface a of the thermoelectric conversion element main body 10 can be manufactured.

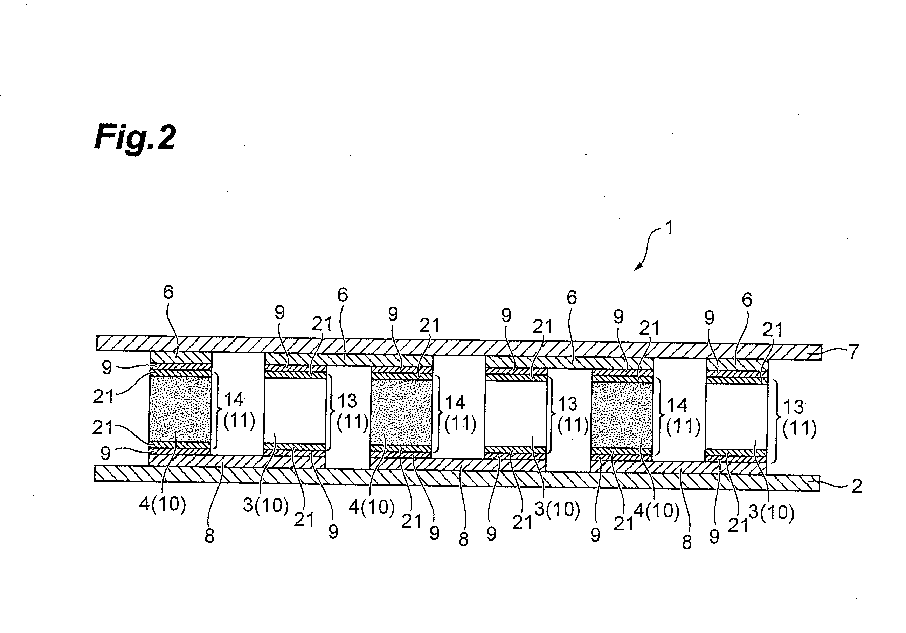

The following is a description of the thermoelectric conversion module using the thermoelectric conversion element 11 obtained as referred to above. Figure 2 is a cross-sectional view of an example of the thermoelectric conversion module 1.

Between a first substrate 2 and a second substrate 7 in the vertically opposing positions, a plurality of p-type thermoelectric conversion elements 13 and a plurality of n-type thermoelectric conversion elements 14 are alternately disposed. The p-type thermoelectric conversion element 13 and the n-type thermoelectric conversion element 14 have the metal layers 21 on the upper surface and the bottom surface of the p-type thermoelectric conversion element main body 3 and the n-type thermoelectric conversion element main body 4, respectively. The metal layer 21 is manufactured by the method as referred to above.

The p-type thermoelectric conversion elements 13 and the n-type thermoelectric conversion elements 14 are electrically connected in series with a plurality of first electrodes 8 and a plurality of second electrodes 6 in the vertically opposing position. The metal layer 21 is bonded to the first electrode 8 on each bottom surface of the p-type thermoelectric conversion element 13 and the n-type thermoelectric conversion element 14, and the metal layer 21 is bonded to the second electrode 6 on each upper surface of the p-type thermoelectric conversion element 13 and the n-type thermoelectric conversion element 14, by using bonding material 9 respectively.

As the bonding materials 9, material having high electric conductivity is preferred. For example, solder and silver brazing alloys are used. According to the thermoelectric conversion module 1 like this, bonding to the electrodes 6 and 8 is easy because the metal layer 21 is formed in advance on each of the thermoelectric conversion elements 13 and 14. Furthermore, due to the high adhesion between the metal layer 21 and each thermoelectric conversion element, a thermoelectric conversion module having high connection reliability and low contact resistance can be realized. Consequently, the power generation efficiency of the thermoelectric conversion module can be enhanced.

Although preferred embodiments of the present invention have been specifically described, the present invention is not limited thereto.

### Examples

Although Examples and Comparative examples will be specifically described hereinafter, the present invention is not limited thereto.

### Example 1

A p-type Ca₃Co₄O₉ sintered body having a cylindrical shape with a diameter of 20 mm and a height of 4 mm was placed on a heater, and the surface temperature of the p-type Ca₃Co₄O₉ sintered body was heated to 700°C ±20°C, and then Ag₂O powder was spread on the surface of the sintered body in an air atmosphere. Consequently, the powder immediately outspread on the surface to form a film, and concurrently the color of the film changed from black to white. After the sintered body was reversed, Ag₂O powder was spread on the reverse surface in a similar way. After the sintered body was cooled down to room temperature, a cube having a side of 4 mm was cut out using a micro cutter. In this way, a cubic-shaped sintered body having upper and bottom surfaces covered by silver was obtained. A resistance between the upper and the bottom surfaces of the obtained cube measured by a multimeter was 0.13 Ω.

### Example 2

In a similar way to Example 1 except that an n-type CaMnO₃ sintered body having a cylindrical shape with a diameter of 15 mm and a height of 4 mm was used, a sintered body having upper and bottom surfaces covered by silver was obtained. In a similar way to the measurement in Example 1, the resistance between the upper and the bottom surfaces of the obtained cube was 0.01 Ω.

### Comparative example 1

A cube having a side of 4 mm was cut out from a p-type Ca₃Co₄O₉ sintered body and silver paste was applied to two opposing surfaces of the cube. After drying, the cube was heated at a temperature of 700°C in an air atmosphere for 30 minutes. After the cube was cooled down to room temperature, in a similar way to the measurement in Example 1, the resistance between the upper and the bottom surfaces of the produced cube was 0.20 Ω.

### Comparative example 2

In a similar way to Comparative example 1 except that an n-type Ca.MnO₃ sintered body was used, a sintered body having upper and bottom surfaces covered by silver paste was produced. After the cube was cooled down to room temperature, in a similar way to the measurement in Example 1, the resistance between the upper and the bottom surfaces of the produced cube was 0.05 Ω.

### Comparative example 3

A cube having a side of 4 mm was cut out from a p-type Ca₃Co₄O₉ sintered body and was overall nickel-plated. Subsequently, the nickel plating attached to the surfaces excluding the upper and bottom surfaces were removed with an abrasive paper. The resistance between the upper and the bottom surfaces of the obtained cube was 140 kΩ. The adhesion between the nickel plating layer and the sintered body was low, and the nickel plating layer peeled off easily.

### Comparative example 4

In a similar way to Comparative example 3 except that an n-type CaMnO₃ sintered body was used, a sintered body having upper and bottom surfaces covered by nickel plating was obtained. In a similar way to the measurement in Example 1, the resistance between the upper and the bottom surfaces of the obtained cube was approximately 150 Ω. The adhesion between the nickel plating layer and the sintered body was low.

### Industrial Applicability

According to the present invention, a method for manufacturing the thermoelectric conversion element to achieve sufficiently low contact resistance is provided.

## Claims

1. A method for manufacturing a thermoelectric conversion element, which comprises a metal layer formation step of comprising spreading a metal compound which decomposes upon heating to generate a metal, on a surface of a thermoelectric conversion element main body heated to the decomposition temperature of the metal compound or higher.

2. The method for manufacturing a thermoelectric conversion element according to claim 1, wherein the metal compound is a silver compound.

3. The method for manufacturing a thermoelectric conversion element according to claim 2, wherein the silver compound is Ag₂O or Ag₂CO₃.

4. The method for manufacturing a thermoelectric conversion element according to claim 1, wherein the metal compound is a metal oxide or a metal carbonate.

5. The method for manufacturing a thermoelectric conversion element according to claim 1, wherein the metal compound is at least one member selected from the group consisting of MnO₃, FeCO₃, Cu₂CO₃, NiCO₃, and MnCO₃.

6. The method for manufacturing a thermoelectric conversion element according to any one of claims 1 to 5, wherein the thermoelectric conversion element main body contains a metal oxide.

7. The method for manufacturing the thermoelectric conversion element according to claim 6, wherein the metal oxide contained in the thermoelectric conversion element main body is Ca₃Co₄O₉ or CaMnO₃.
